# EUROPÄISCHE PATENTSCHRIFT

(11) **EP 3 966 935 B1**
(45) Veröffentlichungstag und Bekanntmachung des Hinweises auf die Patenterteilung: **06.11.2024**
(21) Anmeldenummer: 20724484.9
(22) Anmeldetag: 06.05.2020
(51) Int. Cl.: H03K 17/691

(54) **VORRICHTUNG ZUR ANSTEUERUNG VON HALBLEITER-LEISTUNGSSCHALTERN IM HOCHVOLTBEREICH**
DEVICE FOR CONTROLLING SEMICONDUCTOR CIRCUIT BREAKERS IN THE HIGH-VOLTAGE RANGE
DISPOSITIF DE COMMANDE DE COMMUTATEURS À SEMI-CONDUCTEURS DANS LE DOMAINE DE LA HAUTE TENSION

(30) Priorität: 08.05.2019 DE 102019111996
(43) Veröffentlichungstag der Anmeldung: 16.03.2022
(73) Patentinhaber: Webasto SE, 82131 Stockdorf (DE)
(72) Erfinder: HENNE, Alexander, 82131 Stockdorf (DE); RECHBERGER, Hans, 82131 Stockdorf (DE); FLEDER, Karlheinz, 82131 Stockdorf (DE)
(74) Vertreter: Prüfer & Partner mbB Patentanwälte · Rechtsanwälte
(86) Internationale Anmeldenummer: PCT/EP2020/062587
(87) Internationale Veröffentlichungsnummer: WO 2020/225306

(56) Entgegenhaltungen:
- US-A1- 2016 099 650
- US-A1- 2017 070 220

## Beschreibung

Die Erfindung betrifft eine Vorrichtung zur gleichzeitigen Ansteuerung mehrerer Halbleiter-Leistungsschalter bei gepulsten Lasten im Hochvoltbereich.

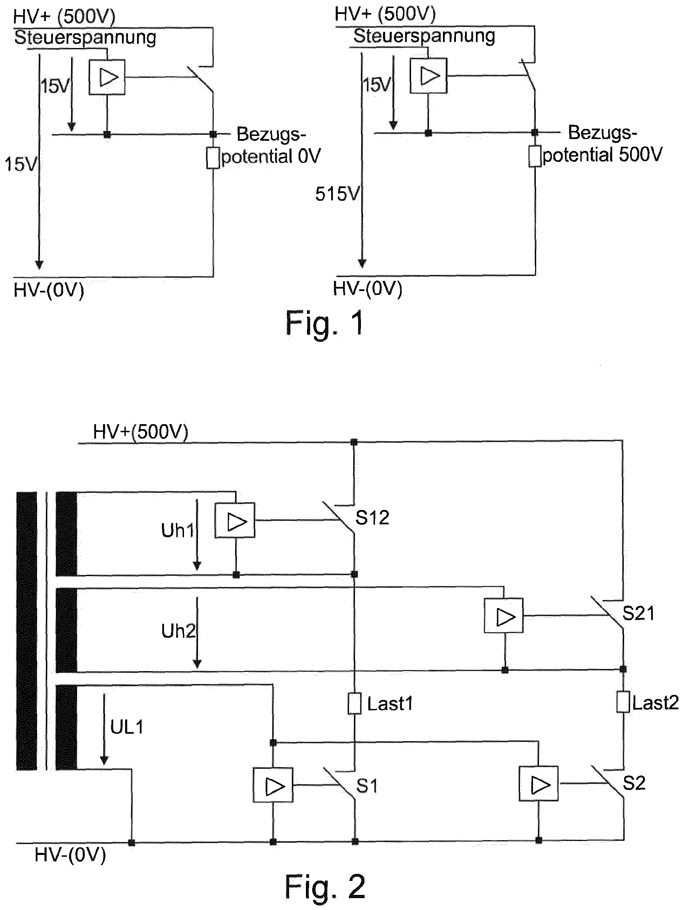

Die Ansteuerung von Halbleiter-Leistungsschaltern mittels herkömmlicher Vorrichtungen der eingangs genannten Art wird anhand der Fig. 1 und 2 erläutert.

Wie in Fig. 1 gezeigt, muss für die Ansteuerung von zwei Halbleiter-Leistungsschaltern (MOSFET, IGBT, Bipolartransistoren) die zur Ansteuerung erforderliche Spannung von 15V am Steuereingang (Gate, Basis) bei durchgeschaltetem Schalter immer einen definierten Potentialunterschied zu einem Bezugspegel haben. Wäre dies nicht der Fall, könnte der Schalter nicht eingeschaltet werden. Im ungünstigsten Fall kann es dabei sogar zur Zerstörung des Halbleiter-Leistungsschalters führen. Der Bezugspegel kann in der in Fig. 1 gezeigten Hochvoltanwendung z. B. auf 0V (Schaltungsvariante links in Fig. 1) oder 500V (Schaltungsvariante rechts in Fig. 1 liegen, er kann sogar von 0 V auf 500 V springen, wenn der Leistungsschalter gesperrt oder durchgeschalten ist (High-Side Problematik).

Für die in Fig. 2 beispielhaft gezeigte Anwendung im Hochvoltbereich erfolgt die Erzeugung von Treiberspannungen UL1, UH₁ und UH₂ mittels eines Transformators mit mehreren Ausgangsspannungen, die galvanisch getrennt die Treiberspannungen auf unterschiedlichen Bezugspegeln bereitstellen. Im Einzelnen werden eine erste Last Last1 und eine zweite Last Last2 jeweils über ein Paar von elektronischen Leistungsschaltern S1, S12 und S2, S21 mit dem Nullpotential HV- und dem Pluspotential HV+ von beispielsweise 500 Volt taktweise verbunden. Die Treiberspannung UL1 zum Ansteuern des Schalters S1 wird von einer ersten Sekundärwicklung des Transformators (in Fig. 2 der unteren Sekundärspannung des Transformators) abgegriffen. Die Treiberspannung Uh₁ zum Ansteuern des Schalters S12 wird von einer zweiten Sekundärwicklung des Transformators (in Fig. 2 der oberen Sekundärspannung des Transformators) abgegriffen. Die Treiberspannung.

Uh₂ zum Ansteuern des Schalters S21 wird von einer dritten Sekundärwicklung des Transformators (in Fig. 2 der oberen Sekundärspannung des Transformators) abgegriffen. Die Hochvoltspannung wird bei geschlossenen Schaltern S1, S12 und S2/ S21 an die jeweilige Last Last1, und Last2 angelegt und bei geöffnetem Schalter von dieser getrennt.

Aufgrund des kompakten Wicklungsaufbaus werden durch Taktung der Leistungshalbleiter hervorgerufene elektromagnetische Störungen auf die Primärseite des Transformators übertragen. In automotiven Applikationen werden damit die im HV-Teil des Gerätes erzeugten Störungen auf die Niedervoltseite übertragen. Zudem können die erzeugten Störungen zu Spannungsspitzen auf den weiteren Sekundärwicklungen des Transformators führen. Diese Störungen müssen relativ aufwendig mit Hilfe von EMV-Filterkomponenten reduziert werden. Ein weiterer Nachteil der Methode ist die Verwendung eines Transformators mit mehreren Sekundärwindungen. Diese sind wegen der geforderten Spannungsfestigkeit und dem Einsatz hochwertiger und damit teureren Isolationsmaterialien aufwendig und teuer.

Aus der US 2017/070220 A1 sind eine Bootstrap-Kompensationsschaltung und ein Leistungsmodul bekannt.

Die US 2016/099650 A1 beschreibt eine Gate-Strom-Versorgungseinrichtung und einen Halbleiterschutzschalter.

Eine Aufgabe der Erfindung besteht darin, eine Vorrichtung derart zu schaffen, dass sie die EMV mäßig optimiert und kostengünstig herstellbar ist.

Gelöst wird diese Aufgabe durch die Merkmale des Anspruchs 1. Vorteilhafte Weiterbildungen der Erfindung sind in den Unteransprüchen festgelegt.

Die Erfindung stellt demnach eine Vorrichtung zur Ansteuerung mehrerer Halbleiter-Leistungsschalter mittels Treiberspannungen zum getakteten Betreiben mehrerer Lasten im Hochvoltbereich bereit. Sie werden über einen Transformator bereitgestellt, wobei die Treiberspannungen für die Halbleiter-Leistungsschalter von einer einzigen Sekundärwicklung des Transformators abgeleitet sind. Es sind Spannungspegelumsetzer-Schaltungen vorgesehen, welche Treiberspannungen mit dem benötigten Spannungspegel aus der in der Sekundärwicklung des Transformators erzeugten Spannung gewinnen.

Bevorzugt ist vorgesehen, dass nur ein Transformator mit nur einer Sekundärwicklung benötigt wird. Die Treiberspannungen für beliebig viele PWM-gesteuerte Lasten werden bevorzugt jeweils über einfache elektronische Spannungspegelumsetzer-Schaltungen erzeugt.

Die erfindungsgemäße Vorrichtung ist im Vergleich zur der nach dem Stand der Technik mit mehreren Sekundärwicklungen kompakter und hat weniger EMV-Störungen.

Der Aufwand für Transformator und EMV-Filterkomponenten wird kleiner und führt zu deutlicher Kostenersparnis.

Die elektronischen Spannungspegelumsetzer-Schaltungen beruhen auf dem Konzept einer Ladungspumpe. Unter dem Begriff Ladungspumpe werden mehrere unterschiedliche elektrische Schaltungen zusammengefasst, die elektrische Spannungen im Wert vergrößern oder Gleichspannungen in ihrer Polarität umkehren.

Ladungspumpen kommen dort als Spannungswandler zum Einsatz, wo keine großen Ausgangströme erforderlich sind oder keine geeigneten magnetischen Bauelemente wie Spulen eingesetzt werden können.

Ladungspumpen setzen durch eine zeitliche Folge zwischen Laden von Kondensatoren und Kaskadieren ihre Spannungen auf einen anderen Wert. Bewerkstelligt wird dies durch periodisches Umschaltung von Schaltern.

Die Vorgänge ähneln der einer Hubkolbenpumpe. Laden der Kondensatoren entspricht dem Füllen des Zylinders und das Kaskadieren dem Hochfahren des Zylinders. Als elektronische Schalter wirken bevorzugt Dioden, die durch Potentialunterschiede jeweils in Sperr- bzw. Durchlassbereiche geschaltet werden und Kondensatoren laden oder ihre Spannung hochsetzen. Ladungspumpen, mehrfach kaskadiert, können sehr hohe Gleichspannungen erzeugen. Solche Schaltungen werden als Hochspannungskaskade bezeichnet.

Dabei dient zur Taktung der jeweiligen Ladungspumpe die Taktung der jeweiligen Last, insbesondere der PWM-Puls der jeweiligen Last zur Taktung der Ladungspumpe verwendet wird. Dadurch vereinfacht sich ihre Schaltungsauslegung stark.

Bevorzugt erfolgt die Taktung der Vorrichtung jeweils über einen Schalter, der an die Sekundärwicklung des Transformators angeschlossen ist, der im geschlossenen Zustand die Ladungspumpe auflädt, und der im geöffneten Zustand die in der Ladungspumpe erzeugte Treiberspannung an den jeweiligen Halbleiter-Leistungsschalter anlegt. Die Ladungspumpen-Taktung erfolgt bevorzugt jeweils über einen PWM-geschalteten Leistungsschalter Sn. So wird z.B. im geschlossenen Zustand von S1 der Kondensator C1 über D1-R1 auf Spannung UL1 geladen. Im geöffneten Zustand entlädt sich C1 über D12 auf C12. Diode D1 sperrt und der geladene Kondensator wird auf den Bezugspegel des Leistungsschalter S12 eingestellt. Mit Uh1=UL1=15V wird der Treiber von S12 mit der nötigen Spannung versorgt.

Nachfolgend wir die Erfindung anhand der Zeichnung näher erläutert; in dieser zeigen:
Fig. 1 zeigt allgemein die Ansteuerung von Halbleiter-Leistungsschaltern (MOSFET, IGBT, Bipolartransistoren) in Übereinstimmung mit dem Stand der Technik,
Fig. 2 zeigt eine Anwendung der Ansteuerung von Fig. 1 im Hochvoltbereich mittels eines Transformators zur galvanischen Trennung der jeweiligen Treiberspannungen für die Leistungsschalter, wobei die Treiberspannungen für die Leistungsschalter mittels Sekundärwicklungen des Transformators galvanisch getrennt sind, und
Fig. 3 zeigt eine Ausführungsform der erfindungsgemäßen Vorrichtung der Ansteuerung von Leistungsschaltern mittels eines Transformators mit einer einzigen Sekundärwicklung, von der die verschiedenen Treiberspannungen für die Leistungsschalter abgeleitet.

Fig. 1 und 2 sind einleitend zum Stand der Technik erläutert.

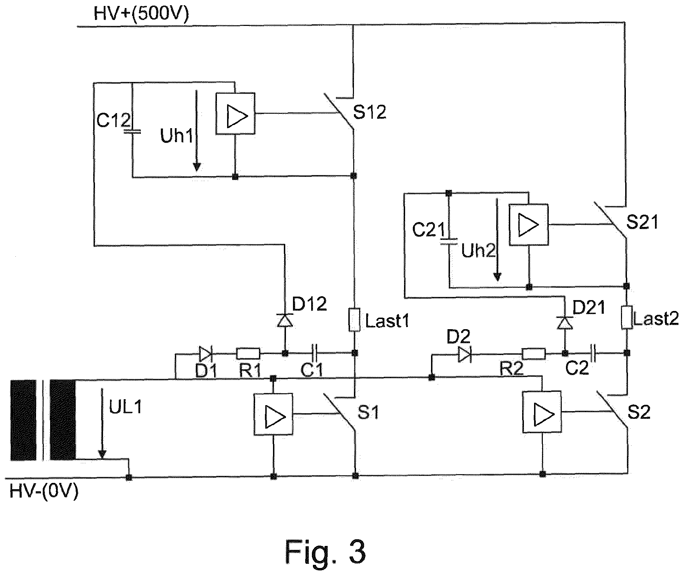

Eine Ausführungsform der erfindungsgemäßen Vorrichtung ist in Fig. 3 gezeigt. Diese Ausführungsform unterscheidet sich von der in Fig. 2 gezeigten Vorrichtung durch die Verwendung eines Transformators mit einer einzigen Sekundärwicklung zur Bereitstellung der Treiberspannung UL1 für die elektronischen Lastschalter S1, S2, genauer gesagt mit der unteren Sekundärwicklung des Transformators mit drei Niveaus des Null-Potentials HV- an die beiden elektronischen Lastenschalter S1 und S2.

Die Treiberspannungen Uh₁ und Uh₂ zur Ansteuerung der elektronischen Lastschalter S12 und S21 werden für die Vorrichtung von Fig. 3 nicht durch weitere Sekundärwicklungen des Transformators bereitgestellt, sondern mittels Ladungspumpen von der einzigen Sekundärspannung des Transformators abgeleitet.

Die Ladungspumpe zur Bereitstellung der Treiberspannung Uh₁ umfasst einen Kondensator C1, der einerseits mit derjenigen Seite der Last Last1 verbunden ist, die am Schalter S1 angeschlossen ist, und andererseits über einen Vorwiderstand R1, dessen anderes Ende mit einer Diode D1 verbunden ist, die auf UL1-Potential liegt.

Die über die Ladungspumpe aus der Spannung UL1 erzeugte Treiberspannung Uh₁ ist über eine Diode D12 an den eingangsseitig von einem Kondensator C12 gebrückten elektronischen Schalter S12 angelegt.

Die Ladungspumpe zur Bereitstellung der Treiberspannung Uh₂ umfasst einen Kondensator C2, der einerseits mit derjenigen Seite der Last Last2 verbunden ist, die am Schalter S2 angeschlossen ist, und andererseits über einen Vorwiderstand R2, dessen anderes Ende mit einer Diode D2 verbunden ist, die auf UL1-Potential liegt. Die über die Ladungspumpe aus der Spannung UL1 erzeugte Treiberspannung Uh₂ ist über eine Diode D12 an den eingangsseitig von einem Kondensator C21 gebrückten elektronischen Schalter S12 angelegt.

Wenn der Schalter S1, geschlossen ist, wird Kondensator C1, C2 über den Vorwiderstand R1, R2 und die Sperrdiode D1, D2 auf das Treiberspannungspotential UL aufgeladen.

Wird der Schalter S1, S2 geöffnet, wird der Kondensator C12, C21 mit der Ladung des Kondensators C1, C2 aufgeladen. Damit steht die zur Ansteuerung des Schalters S12, S21) notwendige Potential Uh₁(Uh₂) = UL zu Verfügung. Dieser Vorgang wird zyklisch mit der Taktung der Schalter S1, S2 wiederholt.

Erläutert wurde die erfindungsgemäße Vorrichtung anhand einer Ausführungsform mit zwei Halbleiter-Leistungsschaltern. Die Erfindung ist jedoch nicht hierauf beschränkt. Vielmehr kommen für die Vorrichtung zur Ansteuerung von Halbleiter-Leistungsschaltern mehr als zwei derartige Schalter in Betracht.

## Patentansprüche

1. Vorrichtung zur gleichzeitigen Ansteuerung mehrerer Halbleiter-Leistungsschalter (S12, S21) für gepulste Lasten (Last 1, Last 2) im Hochvoltbereich,
wobei Treiberspannungen (Uh₁, Uh₂) für die Halbleiter-Leistungsschalter (S12, S21) über einen Transformator bereitstellbar sind,
wobei die Treiberspannungen (Uh₁, Uh₂) für die Halbleiter-Leistungsschalter (S12, S21) aus der Spannung einer einzigen Sekundärwicklung des Transformators abgeleitet sind,
wobei elektronische Spannungspegelumsetzer-Schaltungen vorgesehen sind, um die Treiberspannungen (Uh₁, Uh₂) in einer benötigten Höhe aus der Sekundärwicklung des Transformators zu gewinnen,
wobei die elektronischen Spannungspegelumsetzer-Schaltungen jeweils eine Ladungspumpe (C1, R1, D1; C2, R2, D2) umfassen,
**dadurch gekennzeichnet, dass** zur Taktung der jeweiligen Ladungspumpe die Taktung der jeweiligen Last (Last1, Last2) dient,
wobei die jeweilige Ladungspumpe zur Bereitstellung der entsprechenden Treiberspannung (Uh₁, Uh₂) einen Kondensator (C1, C2) umfasst, der einerseits mit derjenigen Seite der Last (Last1, Last2) verbindbar ist, die nicht mit dem entsprechenden Halbleiter-Leistungsschalter (S12, S21) verbindbar ist, und der andererseits über einen Vorwiderstand (R1, R2) mit einer Diode D1 verbunden und über diese mit der Sekundärwicklung des Transformators verbindbar ist.

2. Vorrichtung nach Anspruch 1, wobei die Taktung der Vorrichtung jeweils über einen Schalter (S1, S2) erfolgt, der an die Sekundärwicklung des Transformators angeschlossen ist, wobei der Schalter (S1, S2) dazu eingerichtet ist, im geschlossenen Zustand die Ladungspumpe aufzuladen, und im geöffneten Zustand die in der Ladungspumpe erzeugte Treiberspannung (Uh₁, Uh₂) an den jeweiligen Halbleiter-Leistungsschalter (S12, S21) anzulegen.

## Claims

1. Device for simultaneously driving a plurality of semiconductor power switches (S12, S21) for pulsed loads (Load 1, Load 2) in the high-voltage range,
wherein driver voltages (Uh₁, Uh₂) for the semiconductor power switches (S12, S21) can be provided via a transformer,
wherein the driver voltages (Uh₁, Uh₂) for the semiconductor power switches (S12, S21) are derived from the voltage of a single secondary winding of the transformer,
wherein electronic voltage level converter circuits are provided in order to obtain the driver voltages (Uh₁, Uh₂) at a required level from the secondary winding of the transformer,
wherein the electronic voltage level converter circuits each comprise a charge pump (C1, R1, D1; C2, R2, D2),
**characterized in that** the clocking of the respective load (Load1, Load2) serves for clocking the respective charge pump,
wherein the respective charge pump for providing the corresponding driver voltage (Uh₁, Uh₂) comprises a capacitor (C1, C2) which can be connected on the one hand to that side of the load (Load1 , Load2) which cannot be connected to the corresponding semiconductor power switch (S12, S21), and which on the other hand is connected via a series resistor (R1, R2) to a diode D1 and can be connected via the latter to the secondary winding of the transformer.

2. Device according to Claim 1, wherein the clocking of the device takes place in each case via a switch (S1, S2) which is connected to the secondary winding of the transformer, wherein the switch (S1, S2) is configured to charge the charge pump in the closed state, and to apply the driver voltage (Uh₁, Uh₂) generated in the charge pump to the respective semiconductor power switch (S12, S21) in the open state.

## Revendications

1. Dispositif de commande simultanée de plusieurs commutateurs de puissance à semi-conducteurs (S12, S21) destinés à des charges pulsées (Last1, Last2) dans la gamme des hautes tensions,
des tensions d'attaque (Uh₁, Uh₂) destinées aux commutateurs de puissance à semi-conducteurs (S12, S21) pouvant être fournies par le biais d'un transformateur, les tensions d'attaque (Uh₁, Uh₂) destinées aux commutateurs de puissance à semi-conducteurs (S12, S21) étant dérivées de la tension d'un seul enroulement secondaire du transformateur,
des circuits électroniques de conversion de niveau de tension étant prévus afin d'obtenir les tensions d'attaque (Uh₁, Uh₂) à un niveau requis à partir de l'enroulement secondaire du transformateur,
les circuits électroniques de conversion de niveau de tension comprenant chacun une pompe de charge (C1, R1, D1 ; C2, R2, D2),
**caractérisé en ce que** la synchronisation de la charge respective (Last1, Last2) est utilisée pour synchroniser la pompe de charge respective,
pour fournir la tension d'attaque correspondante (Uh₁, Uh₂), la pompe de charge respective comprenant un condensateur (C1, C2), qui, d'une part, peut être relié au côté de la charge (Last1, Last2) qui ne peut pas être relié au commutateur de puissance à semi-conducteur correspondant (S12, S21) et qui, d'autre part, est relié à une diode D1 par le biais d'une résistance série (R1, R2) et peut être relié par le biais de ladite diode à l'enroulement secondaire du transformateur.

2. Dispositif selon la revendication 1, la synchronisation du dispositif étant effectuée par le biais d'un commutateur (S1, S2) qui est raccordé à l'enroulement secondaire du transformateur, le commutateur (S1, S2) étant conçu pour charger la pompe de charge à l'état fermé et pour appliquer la tension d'attaque (Uh₁, Uh₂) générée dans la pompe de charge au commutateur de puissance à semi-conducteur respectif (S12, S21) à l'état ouvert.
